Europäisches Patentamt

European Patent Office

Office européen des brevets

(19)

(11) Publication number: **0 253 664 B1**

(12) **EUROPEAN PATENT SPECIFICATION**

(45) Date of publication of patent specification: **14.10.92**  (51) Int. Cl.⁵: **H01L 31/02**, H01L 31/18

(21) Application number: **87306304.4**

(22) Date of filing: **16.07.87**

(54) **Semiconductor photo-sensor and method for manufacturing the same.**

(30) Priority: **16.07.86 JP 166895/86**
**16.07.86 JP 166896/86**
**14.01.87 JP 6899/87**

(43) Date of publication of application:
**20.01.88 Bulletin 88/03**

(45) Publication of the grant of the patent:
**14.10.92 Bulletin 92/42**

(84) Designated Contracting States:
**DE FR GB IT NL**

(56) References cited:
**EP-A- 0 110 518**
**EP-A- 0 186 044**
**US-A- 3 622 419**

**PATENT ABSTRACTS OF JAPAN, vol. 9, no.**
**136 (E-320)[1859], 12th June 1985; & JP-A-60**
**18 941**

**PATENT ABSTRACTS OF JAPAN, vol. 8, no.**
**281 (E-286)[1718], 21st December 1984; & JP-**
**A-59 148 872**

**PATENT ABSTRACTS OF JAPAN, vol. 8, no.**
**211 (P-303)[1648], 26th September 1984; &**
**JP-A-59 95 504**

(73) Proprietor: **CANON KABUSHIKI KAISHA**
**30-2, 3-chome, Shimomaruko, Ohta-ku**
**Tokyo(JP)**

(72) Inventor: **Yoshizawa, Tetsuo**
**6-27-107, Yokodai 5-chome Isogo-ku**
**Yokohama-shi Kanagawa-ken(JP)**
Inventor: **Mihara, Akio**
**3178-2, Yokouchi Hiratsuka-shi**
**Kanagawa-ken(JP)**
Inventor: **Yamashita, Hiromichi**
**4-13 Higashi Nakahara 1-chome**
**Hiratsuka-shi Kanagawa-ken(JP)**
Inventor: **Ohnuki, Ichiro**
**3-3 Kamimeguro 5-chome**
**Meguro-ku Tokyo(JP)**
Inventor: **Suda, Yasuo**
**36-17 Fujigaoka 2-chome Midori-ku**
**Yokohama-shi Kanagawa-ken(JP)**
Inventor: **Ohtaka, Keiji**
**16-24-401 Tamazutsumi 1-chome**
**Setagaya-ku Tokyo(JP)**
Inventor: **Sato, Toshiaki**
**11-20-202 Sagamiohno 8-chome**
**Sagamihara-shi Kanagawa-ken(JP)**

Inventor: **Sugimoto, Taichi**
**1-502 Sagamidaidanchi 5-chome**
**Sagamihara-shi Kanagawa-ken(JP)**

(74) Representative: **Beresford, Keith Denis Lewis et al**
**BERESFORD & Co. 2-5 Warwick Court High Holborn**
**London WC1R 5DJ(GB)**

## Description

The present invention relates to a semiconductor photo-sensor having an encapsulated photoelectric conversion element array for converting incident light to generate electrical signals, and a method for manufacturing the same.

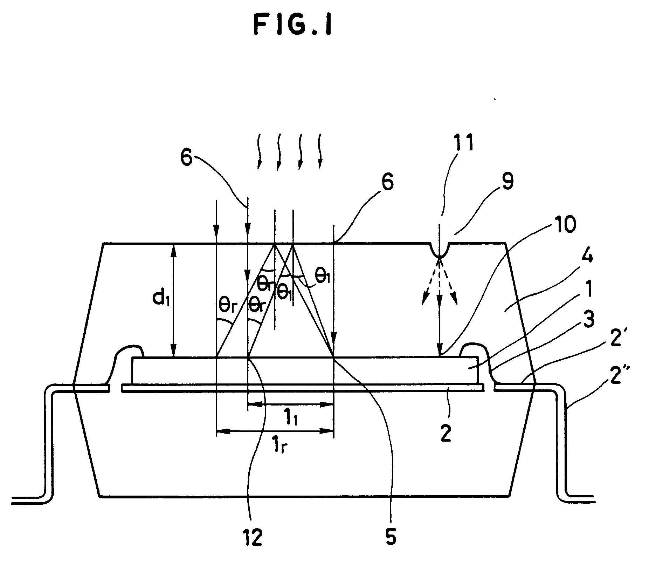

A prior art photo-electric converter for converting incident light to electrical signals is shown in Fig. 1.

A photo-electric conversion element array 1 is fixed on a support member 2, fine metal fly-wires 3 are wire-bonded at predetermined areas on the photo-electric conversion element array 1 to connect these to lead terminals 2', and a light transmissive resin 4 is moulded to form an envelope encapsulating the element 1. Then, external lead parts 2" of the lead terminals 2' are cut to a desired length and bent to complete the semiconductor photo-sensor.

The above prior art semiconductor photo-sensor has the following problems.

(1) When the photo-sensing area of the photo-electric conversion element array comprises a plurality (n) of photo-sensing cells, and uniform illumination applied, the electrical signals derived from the n photosensing cells are not all of the same level as might be expected. Also, when light is applied selectively to one of the n photo-sensing cells and no light is applied to other photo-sensing cells, an electrical signal which is larger than dark current is produced by those other photo-sensing cells to which no light is applied.

(2) If there is a defect on the surface 9 of the light transmissive resin 4, an electrical signal from a photo-sensing cell in the vicinity of an area 10 on the photo-electric conversion element array 1 to which the light passing through the defect reaches, is lowered.

These problems are serious particularly in a semiconductor photo-sensor used for focussing a camera (AF sensor) which has a number of fine photo-sensing cells, because the smaller the area per photo-sensing area, the higher is the sensitivity required. Accordingly, it is generally recognised that resin encapsulation is inapplicable to the AF sensor.

In another prior art semiconductor photo-sensor, an infrared ray blocking filter is mounted on a light transmission surface of the light transmissive resin. In such a semiconductor photo-sensor, in addition to the above-mentioned problem that the electrical signals do not correspond exactly to the pattern of the incident light, the following manufacturing problem arises.

(1) When the light transmissive resin is moulded, mould releasing agent may be deposited on the surface of the resin or a flow is formed during transfer of the mould. These can result in impeding light transmission and can affect adversely the photo-characteristics of the photoelectric conversion element array. Washing and polishing processing is required additionally which results thus in an increase in the manufacturing cost.

(2) When the optical filter is bonded, liquid bonding material is used. Accordingly, it is difficult to ensure vertical positional precision. In order to improve horizontal positional precision, mechanical or optical position detection is required. If it is done by a mechanical unit, it is complex and needs expensive investment.

(3) If an air bubble exists in the bonding material, this also can impede light transmission and affect adversely the photo-characteristics of the photo-electric conversion element array. Accordingly, great care must be taken during the bonding of the optical filter.

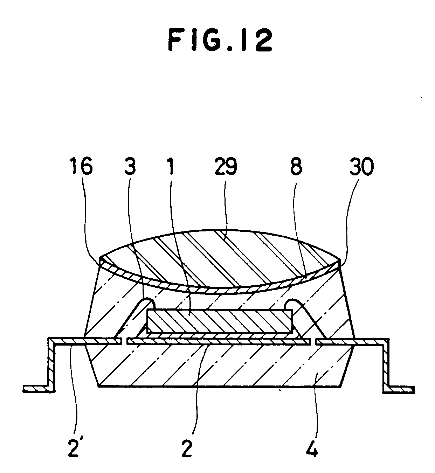

(4) As shown in Fig. 12, when the optical filter is a lens 29, the bonding surface of the light transmissive resin 4 is not planar. Accordingly, the light transmissive resin 4 may have an acute corner 30. In such a case, it is hard to release the mould and a crack may be produced in the resin. This lowers manufacturing yield.

It is observed that the problem of internally reflected light has been recognised hitherto. Specific mention is made of European Patent Application No. 0186044 (Sanyo Electric Co. Ltd.) in which various solutions to this problem are proposed. Such solutions include roughening, recessing, inclining or raising (i.e. forming as convex or concave shape) the bounding surface of the photosensor (i.e. the surface upon which light is first incident).

The present invention is intended to provide a semiconductor photo-sensor having improved characteristics. It is provided as a solution to the problems encountered in prior art semiconductor photosensors as just discussed.

Embodiments of the present invention will provide a semiconductor photo-sensor sealed by a light transmissive resin and in which electrical signals derived from a plurality of photo-sensing cells of the photo-electric conversion element array are equal for a uniform light flux.

Embodiments of the present invention will also provide a semiconductor photo-sensor sealed by light transmissive resin in which the electrical signal from the photo-sensing cells is not attenuated necessarily even when there is a defect present on a surface of the light transmissive resin.

The present invention is intended also to provide method for manufacturing an semiconductor photo-sensor, which is encapsulated in light transmissive resin with a high manufacturing yield and a low manufacturing cost.

In accordance with a first aspect of the present invention there is provided a semiconductor photosensor comprising an array of photo-sensing cells encapsulated in a light transmissive resin;

the photo-sensor being characterised in that the array is located at a depth D from the bounding surface of the photo-sensor on the light incident side of the array, which depth D is not significantly less than $\ell_2/(2 \tan \theta_1)$, wherein $\ell_2$ is a maximum dimension of the area of the array and angle $\theta_1$ is the critical angle of total internal reflection for light internally reflected from the bounding surface.

The above specified choice of depth is found to be expedient in that it eliminates total internal reflection of light from cell to cell and also contributes to reduce the totality of light that is internally reflected onto the array of cells from other regions of the array assembly.

In accordance with a second aspect of the present invention there is provided an autofocus sensor system comprising a photosensor comprised as just described.

The incorporation of an encapsulated photosensor is made practical by this invention since the affects of internal reflection are reduced or eliminated.

In accordance with a third aspect of the present invention there is provided a method of manufacturing a semiconductor photosensor, which photosensor is comprised as just described, this method comprising the following steps:

providing a mould having upper and lower cavities;

placing a light transmissive member on the floor of the lower cavity;

fixing an array of photosensing cells to a lead frame element mount;

locating said array of photosensing cells between the upper and lower cavities such that the array is facing the light transmissive member and is held a distance D above the lower surface of the light transmissive member, which distance D is not significantly less than $\ell_2/(2 \tan \theta_1)$ wherein $\ell_2$ is a maximum dimension of the area of the array and angle $\theta_1$ is the critical angle of total internal reflection for light internally reflected from the lower surface;

injecting resin material into the mould to fill the upper and lower cavities; and

curing the resin material so as to encapsulate the array of photosensing cells in light transmissive resin and to retain the light transmissive member in spaced relation thereto.

Since in the method just described the light transmissive medium is present in the mould, the surface of the light transmissive resin in intimate contact with the light transmissive medium can be formed relatively free of blemish. Of more important note, since the external surface of the light transmissive medium is not formed by this moulding process but is of a surface quality as supplied, it can be provided free of surface blemish in the photosensor produced.

In the drawings:

Fig. 1 shows a sectional view of a prior art semiconductor photo-sensor;

Fig. 2 shows a sectional view of one embodiment of a semiconductor photo-sensor of the present invention;

Fig. 3 shows a sectional view of another embodiment of the semiconductor photo-sensor of the present invention;

Fig. 4 shows an exploded view of an optical system of the semiconductor photo-sensor of the present invention used as an AF sensor of a camera;

Fig. 5 illustrates a principle thereof; and

Fig. 6 to 11 show sectional views of embodiments of a manufacturing method for the semiconductor photosensor of the present invention; and

Fig. 12 shows a semiconductor photo-sensor with a lens filter.

In order that the present invention might be better understood, specific embodiments thereof will be particularised now and reference will be made to the drawings. The description that follows is given by way of example only.

Referring to Fig. 1 causes for the problems encountered in the prior art photo-sensors, which the inventors studied, are explained.

When a light 6 impinges at right angle to the light transmissive resin 4 and the photo-electric conversion element array 1 through an air layer 11, the light is reflected and scattered by a surface 12 of the photo-electric conversion element 1. An intensity of the reflected and scattered light is dependent on an angle depending on material and area of the surface 12. Some of the reflected and scattered light reaches the air layer 11 through the resin 4 and some is reflected at the interface of the air layer 11 and the resin 4.

According to Snell's law, total internal reflection occurs at a certain angle $\theta_1$ which is determined by indices of refraction of the light transmissive resin 4 and the air layer 11. For example, when the indices of refraction of the light transmissive resin 4 and air layer 11 are 1.5 and 1, respectively, the angle $\theta_1$ is approximately 40 degrees and total internal reflection occurs when the internal incident angle is more than 40 degrees. An incident light intensity A at the photo-sensing cell 5 of the photo-electric conversion element 1 is given by

A = [intensity of light 6] + [integration of all reflected lights of lights having an incident angle $\theta_r$

$(\theta_r \geq \theta_1)] + $ [integration of all reflected lights of lights having an incident angle $\theta_r$ $(\theta_r < \theta_1)]$ (1)

In the third term of the formula (1), when $\theta_r$ is smaller than $\theta_1$, reflected light is of very low intensity and it may be neglected, but when $\theta_r$ is close to $\theta_1$, the reflected light intensity is high.

For example, in the known AF sensor, a light shielding A1 film and a passivation film are laminated on an area other than the photo-sensing area. Since the A1 film has a certain surface roughness, incident light is diffusely reflected by the A1 film. In the AF sensor, the incident light is not always directed normally to the photo-sensing area but directed at an angle. In such a case, light which is reflected at an angle close to the total reflection angle is increased.

The inventors have made the following theoretical assumption. The intensity of the light to the photo-sensing cell 5 is a sum of the light intensity of the light 6 and light intensities of light reflected from the vicinity of the circumference and outside of a circle centered at the photo-sensing cell 5 on the photoelectric conversion element array 1 and having a radius $\ell_1$. The latter spurious reflected light causes a degradation in the optical characteristics.

The inventors, after further study, have attained excellent results in semiconductor photo-sensor construction and performance.

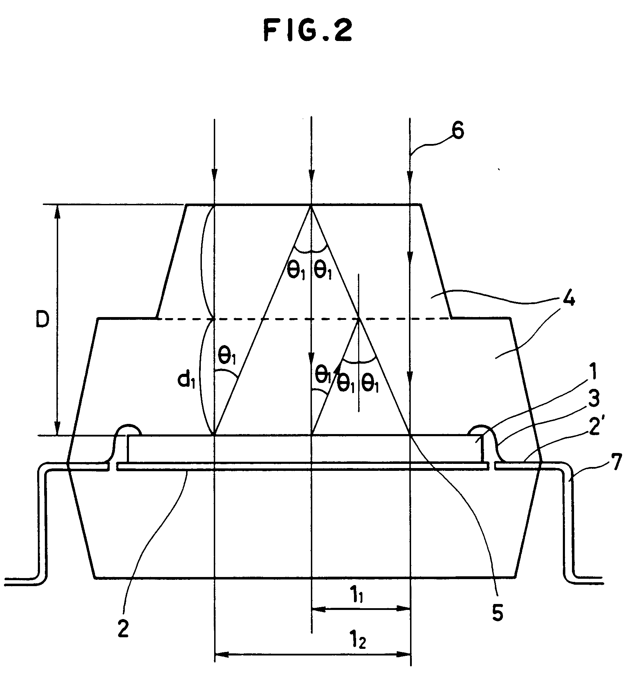

Fig. 2 shows a sectional view of a first embodiment of the semiconductor photo-sensor of the present invention. In Fig. 2, like numerals to those shown in Fig. 1 designate like elements. The photo-electric conversion element array 1 is fixed to the photo-electric element support member 2, fine metal wires 3 are bonded to predetermined areas of the photo-electric conversion element array 1 and to lead terminals 2', and a light transmissive resin 4 is moulded by a mould e.g. a transfer mould to form an encapsulating envelope. The mould used has a larger distance between the light transmissive surface and the photo-electric conversion element array than that of the prior art photosensor. In Fig. 2, $d_1$ represents a distance between the sealant surface and the photo-electric conversion element array 1 of the prior art semiconductor photo-sensor, and $d_1 + d_2$ represents a distance between the light transmissive surface of the sealant and the photo-electric conversion element array 1 of the present invention. In the prior art photosensor, $D = d_1$ while in the present invention, $D = d_1 + d_2$ $(d_2 > 0)$. Then, the external leads 7 of the lead terminals 2' are cut to a desired length and bent to complete the semiconductor photo-sensor.

The intensity of light applied to the photo-sensing element 5 of the photo-electric conversion element array 1 is given by the following formula,

where $\theta_1$ is the total internal reflection angle given by Snell's law.

A = (an intensity of the light 6) + (sum of intensities of lights in the vicinity of circumference and outside of circle having the radius $\ell_1$ on the photo-sensitive conversion element 1) (2)

On the other hand, the light intensity in the semiconductor photo-sensor of the present invention is given by the following formula, where $d_2 \neq 0$.

A = (an intensity of the light 6) + (sum of intensities of lights reflected by the vicinity of circumference and outside of the circle having a radius $\ell_2$ on the photo-electric conversion element 1) (3)

In the formula (3),

$\ell_1 = 2d_1 \tan \theta_1$
$\ell_2 = 2(d_1 + d_2) \tan \theta_1$
$\ell_2 - \ell_1 = 2d_2 \tan \theta_1$

($\theta_1$ and $\ell_1$ are constant)
Accordingly, the larger $d_2$ is, the larger is the difference $\ell_2 - \ell_1$, the smaller is the area to which the reflected light is applied and the smaller is the effect of reflection. Since light intensity is inversely proportional to square of light path length, the absolute value of intensity of the reflected light in the present invention is reduced because the light path length is long, and hence the effect is reduced. In order to reduce the effect of the reflected light, an area other than the photo-sensing area of the photo-electric conversion element array 1 is masked to block the light in order to reduce the effect of the reflected light from the other than photo-sensing area, and $d_2$ and the shape of the light transmissive surface of the sealant are so designed that the photo-sensing cells of the photo-electric conversion element array 1 can be located within the circle having the radius $\ell_2$. If the light impinges on area other than the photo-sensing area of the photo-electric conversion element array 1 even with the masking, or if the photo-sensing cell must be located outside the circle having the radius $\ell_2$, the effect can be predicted and $d_2$ and the shape of the light transmissive surface of the sealant can be designed to minimise the effect.

Semiconductor photo-sensors of the present invention comprehend sensors which can be highly sensitive to light such as line sensors or area sensors, in which the photo-electric conversion element array comprises a number of photo sensing cells such as CCD's.

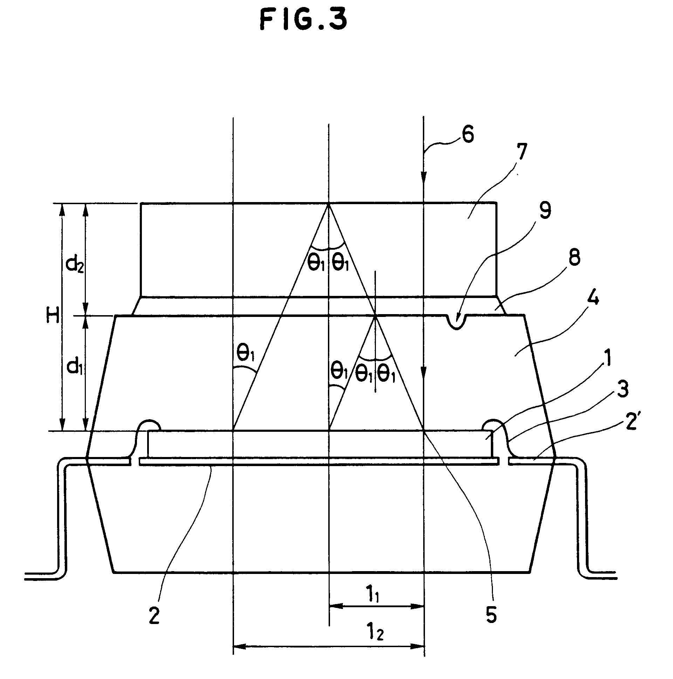

Fig. 3 shows a sectional view of a second embodiment of the semiconductor photo-sensor of the present invention. In Fig. 3, like numerals to those shown in Fig. 2 designate like elements.

In the present embodiment, the bulky portion ($d_2$) is made of glass instead of light transmissive resin as used in the construction shown in Fig. 2.

In Fig. 3, a bonding layer 8 bonds the sealant 4 to the glass 7 and is made of light transmissive resin. The light transmissive resin used for the bonding layer may be or may not be same as that of the sealant 4. When they are same, the glass 7 can be introduced when the light transmissive resin 4 is formed by the transfer 7 mould method and the glass can then be bonded and held by the light transmissive resin 4 itself.

The thickness and shape of the glass 7 are determined by the same conditions as those imposed for the bulky portion of the first embodiment. In the present embodiment, in addition to the effect of the first embodiment, the effect on the optical characteristics is reduced because the defect on the surface 9 of the light transmissive resin 4 is filled by a light transmissive resin 8 having substantially the same index of refraction as that of the light transmissive resin 4, or the defect is not formed on the surface since the glass 7 is bonded and held in intimate contact with the light transmissive resin 4.

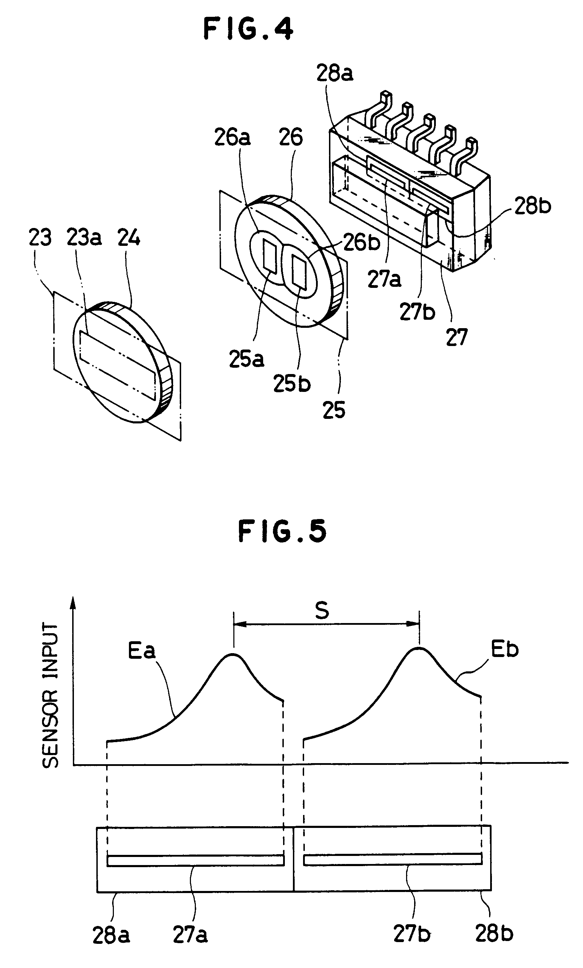

Fig. 4 shows an exploded view of an optical system where the semiconductor photo-sensor of the present invention is used as an AF sensor of a camera. Numerals 23 - 28 denote parts of a focus detection unit (AFU). Numeral 23 denotes a view field mask arranged near a focal plane, numeral 24 denotes a field lens, numeral 25 denotes a focusing beam splitting mask having apertures 25a and 25b, numeral 26 denotes a secondary focusing lens and numeral 26a and 26b denotes lens areas. Numeral 27 denotes a focus sensor array having a pair of line sensors 27a and 27b each having a sub-array of pixel cells linearly arranged.

Numerals 28a and 28b denote images of 23a projected by the lens areas 26a and 26b of the secondary focusing lens 26. A dimension of the aperture 25a is so designed that the edges of the images 28a and 28b are closely adjacent to each other. Numeral 24 denotes a lens for directing the light beam to the focusing light beam splitting mask 25 and the secondary focusing lens 26.

In the present optical system, the light beam which passed through the imaging lens is focused on 23, passes through the apertures 25a and 25b and refocused into 28a and 28b on the line sensors 27a and 27b by the lens areas 26a and 26b, respectively. By detecting a relative position of two images on the line sensors 27a and 27b, an in-focus state is checked.

Fig. 5 illustrates a principle thereof. Ea and Eb denote outputs of the images projected on the line sensors 27a and 27b, respectively. In the in-focus state, a distance S between the two images assumes $S_0$. If the imaging lens is not in the in-focus state, $S \neq S_0$. In order to detect this, brightness distribution Ea and Eb are relatively bit-shifted to correlate the two images.

If light is directed from each image 28a, 28b back to the same image 28a, 28b or to the other image 28b, 28a by internal reflection, then Ea and Eb are of different shapes than those of true object brightness distribution and the correlation is carried out with different information than the true objection information. As a result, focus information detected includes an error.

This semiconductor photo-sensor reduces the effects of internal reflection and here provides correct focus information. Accordingly, it overturns the existing doctrine that "resin encapsulation is not applicable to the Af sensor".

A method suitable for manufacturing the semiconductor photo-sensor of the present invention is now explained.

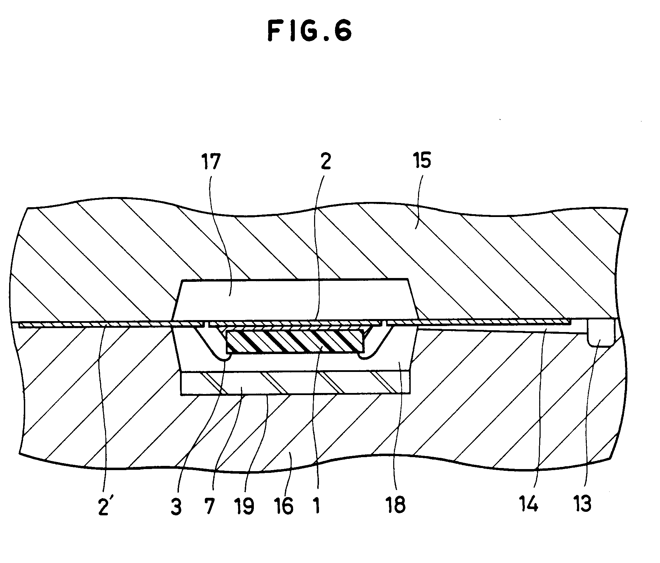

In Fig. 6 to 11, like numerals to those shown in Figs. 1 to 3 designate like elements.

Referring to Fig. 6:

(1) The photo-electric conversion element array 1 for converting light to electrical signal is fixed by bonding material to a bottom surface of the lead frame element mount 2.

(2) The lead frame element mount 2 and the photo-electric conversion element array 1 are electrically connected by fine metal wires 3. By the steps (1) and (2), a major portion of the semiconductor photo-sensor is formed.

(3) The glass 7 is inserted into a recess 19 formed in a cavity of a lower mold 16.

(4) The major portion of the semiconductor photo-sensor formed in the steps (1) and (2) is arranged in the lower mold 16 at a position facing the glass 7, and an upper mold 15 is closed.

(5) The light transmissive resin 4 is injected from a runner 13 and a gate 14 into the upper mold cavity 17 and the lower mold cavity 18.

(6) Heat is applied to the upper mold 15 and the lower mold 16 to seal the main portion of the semiconductor photo-sensor by the injected light transmissive resin 4.

(7) The upper mold 15 and the lower mold 16 are removed.

(8) The exposed areas of the lead frame leads 2 are plated.

(9) Unnecessary portions of the lead frame leads are cut away.

(10) External leads are bent.

Bonding material is not used and the light transmissive resin and the optical filter are paired in intimate contact. Accordingly, the following advantages are offered.

(1) The number of steps is reduced.

(2) The light transmissive resin 4 injected into the cavity 18 is formed on the pre-arranged optical filter 7. The internal surface of the light transmissive resin contacts the glass 7 intimately and it is not moulded by the mould. Accordingly, the deterioration of the light transmissivity due to the mould releasing agent deposited during moulding or the crack created by the transfer is prevented.

(8) Since the glass 7 is arranged in the lower mould 16, no special position detector is required and the positioning precision is improved. Vertical, longitudinal and lateral position can be determined freely by appropriately selecting the shape of mould.

(4) Since no bonding layer exists in the light path, the degradation of the light transmissivity due to the generation of air bubble in the bonding material is prevented.

(5) A lens may be provided as the light transmissive member. Although the resin introduced is then shaped to have an acute angled portion at the edge of the lens, this portion is not completely surrounded by the mould and does not therefore lead to problems of cracking.

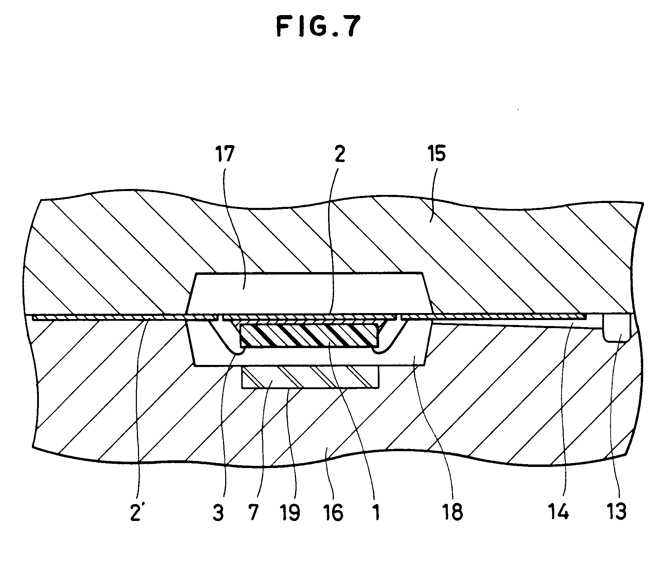

Fig. 7 shows a sectional view of a second embodiment of the present invention.

In the present embodiment, since a recess 19 is formed in the lower mould 16, the glass 7 is positioned by the recess 19 even if the glass 7 is smaller than the light transmissive resin light path surface. Accordingly, the position of the glass 7 in the final product is very accurate.

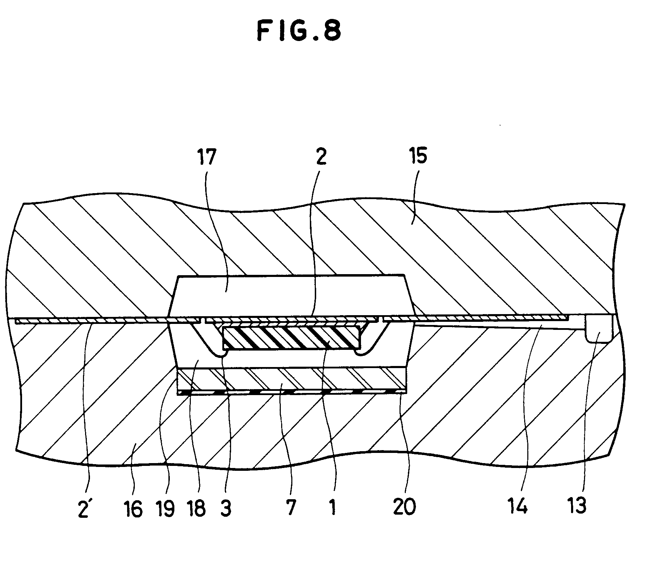

Fig. 8 shows a sectional view of a third embodiment of the present invention. In the present embodiment, silicone grease is applied to the bottom of the recess 19 and the glass 7 is mounted thereon. Accordingly, resin does not penetrate into the interface between lower mould 16 and the glass 7.

A casting mould, transfer mould or injection mould may be used in this method. Depending on the manufacturing condition the resin may penetrate into the space between the glass 7 and the recess 19 of the lower type 16. The resin so penetrated is deposited thinly on the glass 7 and light transmissivity is impeded by diffuse reflection. The third embodiment shown in Fig. 8 is particularly effective to prevent the above problem.

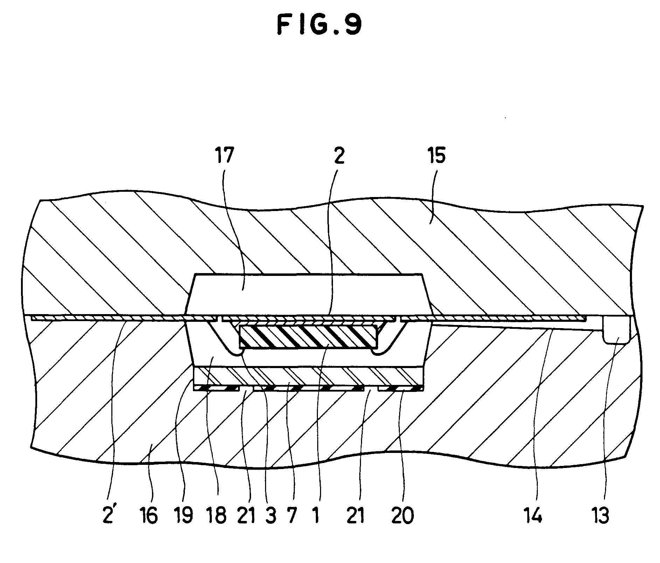

Fig. 9 shows a sectional view of a fourth embodiment of the present invention.

In the present embodiment, a projection 21 is formed on the bottom of the lower mould 16 so that the glass 7 is held by the projection 21. Accordingly, the vertical position of the glass 7 is defined even if silicone grease 20 is used.

In the fourth embodiment, since the glass 7 is held by the viscosity of the silicone grease 20, the optical filter 7 does not drop even if the glass 7 is mounted on the upper mold 15.

In the third and fourth embodiments, silicone grease is used. Alternatively, other viscous material such as wax such as carnoubarrow, oil such as silicone oil or grease other than silicon grease.

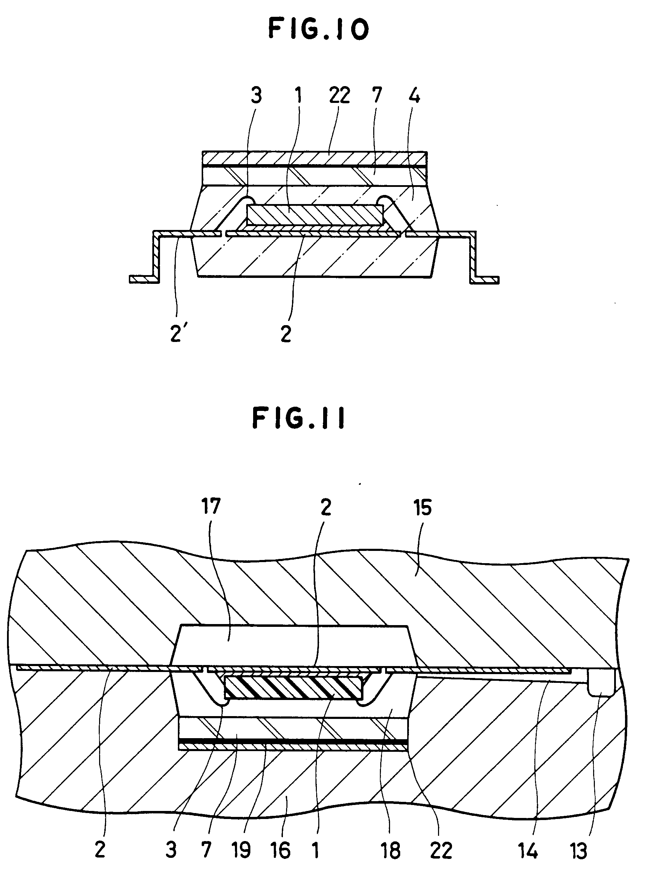

Figs. 10 and 11 show a fifth embodiment. In the present embodiment, an adhesive tape 22 is applied to one surface (facing the lower mold 16) of the glass 7 is formed in the step (3) of the first embodiment. Namely, the adhesive tape 22 is arranged in the interface between the glass and the lower mold 12.

The adhesive tape 22 is removed from the glass 7 after the step (7) of the first embodiment. Other steps are identical to those of the first embodiment.

By applying the adhesive tape 22, flakes created by the penetration of the resin into the interface between the glass 7 and the lower mold 16 are removed when the adhesive tape 22 is peeled off the glass 7.

The adhesive tape should have a heat resistivity (to withstand a temperature of approximately 150°C applied when the resin is molded or heated) and there is no restriction so long as it has such heat resistivity. The adhesive material of the adhesive tape may be epoxy resin, epoxy phenol resin (which has a heat resistivity of up to 180°C for continuous heating), vinyl chloride resin, polyimide or polyamide-imide.

In general, the material of the photo-electrical conversion element array, the division of the photo-sensing surface and the circuit may be selected from various alternatives depending on the application and purpose of the semiconductor photo-sensor. One application is an image pick-up, plane-divided silicon photo-electric conversion element array. While the glass and lens are used as the light transmissive member on the light transmissive resin in the above embodiments, optical filter, polarization plate or concave lens may be used depending on the application and purpose of the semiconductor photo-sensor.

In general, the light transmissive resin is selected in accordance with the application and object of the semiconductor photo-sensor and it should be light transmissive and adhesive as well as resistive to heat and water.

For example, when an operable wavelength range of the semiconductor photo-sensor is a visible light range of 300 $\mu$m to 1000 $\mu$m and the material of the light transmissive member is glass, the resin is preferably hardened acid anhydride of bis-phenol type A epoxy resin from the standpoints of light transmissivity, adhesivity and reliability.

In the examples of method just described, the light transmissive resin is not affected by the mould or the mould releasing agent, and a resin seal having an excellent light transmissivity is attained. The optical characteristic of the semiconductor photo-sensitive material is significantly improved. The positioning of the light transmissive member to the light transmissive resin is facilitated, the total number of steps is reduced and the manufacturing cost is reduced. Further, even if a lens or other non-planar member is used as the light transmissive member, crack is not created when the mould is released.

## Claims

1. A semiconductor photo-sensor comprising an array (1) of photo-sensing cells encapsulated in a light transmissive resin (4); said photosensor being characterised in that said array (1) is located at a depth D from the bounding surface of said photosensor on the light incident side of said array (1), which depth D is not significantly less than $\ell_2/(2 \tan \theta_1)$, wherein $\ell_2$ is a maximum dimension of the area of said array (1) and angle $\theta_1$ is the critical angle of total internal reflection for light internally reflected from said bounding surface.

2. A photosensor as claimed in claim 1 wherein that portion of said photosensor between said array (1) and said bounding surface is composed of said light transmissive resin (4).

3. A photosensor as claimed in claim 1 wherein that portion of the photosensor between said array (1) and said bounding surface is of a composite structure comprising both said encapsulating light transmissive resin (4) and a light transmissive member (7; 29) of material different to that of said resin (4).

4. A photosensor as claimed in claim 3 wherein there is a bonding layer (8) interposed between said encapsulating light transmissive resin (4) and said light transmissive member (7;29).

5. A photosensor as claimed in claim 3 wherein said light transmissive member (7) is provided set in said light transmissive resin (4) with the respective internal surfaces thereof being thus in intimate contact.

6. A photosensor as claimed in any one of claims 3 to 5 wherein said light transmissive member (7;29) is of glass.

7. An autofocus sensor system including a photosensor comprising an array (1) of photo-sensing cells as defined in any one of claims 1 to 6.

8. A method of manufacturing a semiconductor photosensor, which photosensor is as defined in claim 3, said method comprising the following steps:
providing a mould (15,16) having upper and lower cavities (17,18);
placing a light transmissive member (7) on the floor of said lower cavity (18);
fixing an array (1) of photosensing cells to a lead frame element mount;
locating said array (1) of photosensing cells between said upper and lower cavities (17,18) such that said array (1) is facing the light transmissive member (7) and is held a distance D above the lower surface of said light transmissive member (7), which distance D is not significantly less than $\ell_2/(2 \tan \theta_1)$ wherein $\ell_2$ is a maximum dimension of the area of said array (1) and angle $\theta_1$ is the critical angle of total internal reflection for light internally reflected from said lower surface;
injecting resin material into said mould to fill said upper and lower cavities (17, 18); and
curing said resin material so as to encapsulate said array (1) of photosensing cells in light transmissive resin (4) and to retain said light transmissive member (7) in spaced relation thereto.

9. A method as claimed in claim 8 wherein said lower cavity (18) of the mould (15) has a recess (19) and said light transmissive member (7) is placed therein.

10. A method as claimed in claim 8 wherein the floor of said lower cavity (18) of the mould (15,16) is coated with a barrier agent (20) prior to placing said light transmissive member (7) thereon, which barrier agent (20) is provided to prevent ingress of injected resin material between said floor and said lower surface of said light transmissive member (7).

11. A method as claimed in claim 10 wherein said barrier agent is a material selected from the materials carnauba, silicone oil and silicon grease.

12. A method as claimed in either of claims 10 or 11 wherein said floor of said lower cavity (18) of said mould (15, 16) is provided with a plurality of pedestal projections (21) so that said light transmissive member (7) may be placed with its lower surface at a precise distance from said floor of said lower cavity (18).

13. A method as claimed in claim 8 wherein an adhesive tape (22) is provided between said lower surface of said light transmissive member (7) and said floor of said lower cavity (18); and
said adhesive tape (22) is peeled from said lower surface of said light transmissive member (7) to remove any surplus of light transmissive resin formed thereon.

14. A method as claimed in any one of claims 10 to 12 when performed with said mould (15, 16) inverted, said barrier agent (20) then acting also to retain said light transmissive member in position above said array (1) of photosensing cells during injection and curing.

15. Use of an encapsulated semiconductor photosensor, being a photosensor as defined in any of claims 1 to 6, in an autofocus sensor system for reducing the sum total of light that is internally reflected within said photosensor.

**Patentansprüche**

1. Halbleiterphotosensor mit einer Anordnung (1) von Lichtfühlzellen, die in einem lichtdurchlässigen Harz (4) eingekapselt sind,
wobei der Photosensor dadurch gekennzeichnet ist, daß sich die Anordnung (1) in einer Tiefe D von der Grenzfläche des Photosensors an der Lichteinfallseite der Anordnung (1) befindet, wobei diese Tiefe D nicht bedeutend kleiner als $\ell_2/(2 \tan \theta_1)$ ist, worin $\ell_2$ eine größte Abmessung des Bereichs der Anordnung (1) ist und der Winkel $\theta_1$ der Grenzwinkel der inneren Totalreflexion für Licht ist, das innen von der Grenzfläche reflektiert wird.

2. Photosensor nach Anspruch 1, bei dem der Teil des Photosensors, der zwischen der Anordnung (1) und der Grenzfläche liegt, aus dem lichtdurchlässigen Harz (4) besteht.

3. Photosensor nach Anspruch 1, bei dem der Teil des Photosensors, der zwischen der Anordnung (1) und der Grenzfläche liegt, eine Verbundstruktur hat, die aus dem einkapselnden lichtdurchlässigen Harz (4) und einem lichtdurchlässigen Bauteil (7; 29) aus einem Material, das von dem des Harzes (4) verschieden ist, besteht.

4. Photosensor nach Anspruch 3, bei dem zwischen dem einkapselnden lichtdurchlässigen Harz (4) und dem lichtdurchlässigen Bauteil (7; 29) eine Verbindungsschicht (8) angeordnet ist.

5. Photosensor nach Anspruch 3, bei dem das lichtdurchlässige Bauteil (7) in das lichtdurchlässige Harz (4) eingesetzt ist, so daß ihre jeweiligen inneren Oberflächen in inniger Berührung sind.

6. Photosensor nach einem der Ansprüche 3 bis 5, bei dem das lichtdurchlässige Bauteil (7; 29) aus Glas besteht.

7. Sensorsystem für automatische Scharfeinstellung, das einen Photosensor mit einer Anordnung (1) von Lichtfühlzellen enthält, wie er in einem der Ansprüche 1 bis 6 definiert ist.

8. Verfahren zur Herstellung eines Halbleiterphotosensors, wobei dieser Photosensor wie in Anspruch 3 definiert ist, wobei das Verfahren die folgenden Schritte umfaßt:
Bereitstellen einer Form (15, 16) mit einer oberen und einer unteren Formhöhlung (17, 18),
Auflegen eines lichtdurchlässigen Bauteils (7) auf den Boden der unteren Formhöhlung (18),
Befestigen einer Anordnung (1) von Lichtfühlzellen an einem Leitungsrahmenelementträger,
örtliches Festlegen der Anordnung (1) von Lichtfühlzellen zwischen der oberen und der unteren Formhöhlung (17, 18) derart, daß die Anordnung (1) dem lichtdurchlässigen Bauteil (7) gegenüberliegt und in einem Abstand D oberhalb der unteren Oberfläche des lichtdurchlässigen Bauteils (7) gehalten wird, wobei dieser Abstand D nicht bedeutend kleiner als $\ell_2/(2 \tan \theta_1)$ ist, worin $\ell_2$ eine größte Abmessung des Bereichs der Anordnung (1) ist und der Winkel $\theta_1$ der Grenzwinkel der inneren Totalreflexion für Licht ist, das innen von der unteren Oberfläche reflektiert wird,
Einspritzen von Harzmaterial in die Form, um die obere und die untere Formhöhlung (17, 18) auszufüllen, und
Härten des Harzmaterials, um die Anordnung (1) von Lichtfühlzellen in dem lichtdurchlässigen Harz (4) einzukapseln und das lichtdurchlässige Bauteil (7) in einem Abstand davon zu halten.

9. Verfahren nach Anspruch 8, bei dem die untere Formhöhlung (18) der Form (15) eine Vertiefung (19) hat und das lichtdurchlässige Bauteil (7) dareingelegt wird.

10. Verfahren nach Anspruch 8, bei dem der Boden der unteren Formhöhlung (18) der Form (15, 16) mit einem Sperrmittel (20) beschichtet wird, bevor das lichtdurchlässige Bauteil (7) daraufgelegt wird, wobei dieses Sperrmittel (20) bereitgestellt wird, um das Eindringen von eingespritztem Harzmaterial zwischen dem erwähnten Boden und der unteren Oberfläche des lichtdurchlässigen Bauteils (7) zu verhindern.

11. Verfahren nach Anspruch 10, bei dem das Sperrmittel ein Material ist, das aus den Materialien Carnaubawachs, Siliconöl und Siliconfett ausgewählt ist.

12. Verfahren nach Anspruch 10 oder 11, bei dem der Boden der unteren Formhöhlung (18) der Form (15, 16) mit einer Vielzahl von sockelartigen Vorsprüngen (21) versehen ist, so daß das lichtdurchlässige Bauteil (7) mit einem genauen Abstand seiner unteren Oberfläche von dem Boden der unteren Formhöhlung (18) angeordnet werden kann.

13. Verfahren nach Anspruch 8, bei dem zwischen der unteren Oberfläche des lichtdurchlässigen Bauteils (7) und dem Boden der unteren Formhöhlung (18) ein Klebeband (22) bereitgestellt wird und
das Klebeband (22) von der unteren Oberfläche des lichtdurchlässigen Bauteils (7) abgeschält wird, um einen etwaigen Überschuß von darauf gebildetem lichtdurchlässigem Harz zu entfernen.

14. Verfahren nach einem der Ansprüche 10 bis 12, wenn es mit der umgekehrten Form (15, 16) durchgeführt wird, wobei das Sperrmittel (20) in diesem Fall auch derart wirkt, daß es das lichtdurchlässige Bauteil während des Einspritzens und Härtens in der richtigen Lage oberhalb der Anordnung (1) von Lichtfühlzellen hält.

15. Verwendung eines eingekapselten Halbleiterphotosensors, der ein Photosensor ist, wie er in einem der Ansprüche 1 bis 6 definiert ist, in einem Sensorsystem für automatische Scharfeinstellung zur Verminderung der Gesamtsumme des Lichts, das in dem Photosensor innen reflektiert wird.

**Revendications**

1. Photocapteur à semiconducteurs comportant un réseau (1) de cellules photocaptrices encapsulées dans une résine (4) transmettant la lumière ;
ledit photocapteur étant caractérisé en ce que ledit réseau (1) est situé à une profondeur D de la surface de délimitation dudit photocapteur sur le côté d'incidence de la lumière dudit réseau (1), laquelle profondeur D n'est pas notablement inférieure à $\ell_2/(2\ tg\ \theta_1)$, où $\ell_2$ est une dimension maximale de l'aire dudit réseau (1) et l'angle $\theta_1$ est l'angle critique de la réflexion interne totale pour de la lumière réfléchie de façon interne depuis ladite surface de délimitation.

2. Photocapteur selon la revendication 1, dans lequel la partie dudit photocapteur située entre ledit réseau (1) et ladite surface de délimitation est composée de ladite résine (4) transmettant la lumière.

3. Photocapteur selon la revendication 1, dans lequel la partie du photocapteur située entre ledit réseau (1) et ladite surface de délimitation est d'une structure composite comprenant à la fois ladite résine (4) d'encapsulation transmettant la lumière et un élément (7 ; 29) transmettant la lumière en une matière différente de celle de ladite résine (4).

4. Photocapteur selon la revendication 3, dans lequel il y a une couche (8) de liaison interposée entre ladite résine d'encapsulation (4) transmettant la lumière et ledit élément (7 ; 29) transmettant la lumière.

5. Photocapteur selon la revendication 3, dans lequel ledit élément (7) transmettant la lumière est positionné dans ladite résine (4) transmettant la lumière de façon que leurs surfaces internes respectives soient ainsi en contact intime.

6. Photocapteur selon l'une quelconque des revendications 3 à 5, dans lequel ledit élément (7 ; 29) transmettant la lumière est en verre.

7. Système capteur pour mise au point automatique comprenant un photocapteur comportant un réseau (1) de cellules photocaptrices selon l'une quelconque des revendications 1 à 6.

8. Procédé de fabrication d'un photocapteur à semiconducteurs, lequel photocapteur est tel que défini dans la revendication 3, ledit procédé comprenant les étapes suivantes qui consistent :
à prévoir un moule (15, 16) ayant des cavités supérieure et inférieure (17, 18) ;
à placer un élément (7) transmettant la lumière sur le fond de ladite cavité inférieure (18) ;
à fixer un réseau (1) de cellules photocaptrices à une monture d'éléments de cadre de montage ;

à placer ledit réseau (1) de cellules photocaptrices entre lesdites cavités supérieure et inférieure (17, 18) de manière que ledit réseau (1) soit tourné face à l'élément (7) transmettant la lumière et soit maintenu à une distance D au-dessus de la surface inférieure dudit élément (7) transmettant la lumière, laquelle distance D n'est pas notablement inférieure à $\ell_2/(2\ tg\ \theta_1)$ où $\ell_2$ est une dimension maximale de l'aire dudit réseau (1) et l'angle $\theta_1$ est l'angle critique de la réflexion interne totale pour de la lumière réfléchie de façon interne depuis ladite surface inférieure ;

à injecter une matière du type résine dans ledit moule pour remplir lesdites cavités supérieure et inférieure (17, 18) ; et

à faire mûrir ladite matière du type résine afin d'encapsuler ledit réseau (1) de cellules photocaptrices dans une résine (4) transmettant la lumière et de retenir ledit élément (7) transmettant la lumière à distance de ce réseau.

9. Procédé selon la revendication 8, dans lequel ladite cavité inférieure (18) du moule (15) présente un évidement (19) dans lequel est placé ledit élément (7) transmettant la lumière.

10. Procédé selon la revendication 8, dans lequel le fond de ladite cavité inférieure (18) du moule (15, 16) est revêtu d'un agent d'arrêt (20) avant la mise en place sur ce fond dudit élément (7) transmettant la lumière, lequel agent d'arrêt (20) est destiné à empêcher l'intrusion de la matière du type résine injectée entre ledit fond et ladite surface inférieure dudit élément (7) transmettant la lumière.

11. Procédé selon la revendication 10, dans lequel ledit agent d'arrêt est une matière choisie parmi le carnauba, l'huile aux silicones et la graisse aux silicones.

12. Procédé selon l'une des revendications 10 et 11, dans lequel ledit fond de ladite cavité inférieure (18) dudit moule (15, 16) est pourvu de plusieurs saillies (21) de support afin que ledit élément (7) transmettant la lumière puisse être placé avec sa surface inférieure à une distance précise dudit fond de ladite cavité inférieure (18).

13. Procédé selon la revendication 8, dans lequel un ruban adhésif (22) est prévu entre ladite surface inférieure dudit élément (7) transmettant la lumière et ledit fond de ladite cavité inférieure (18) ; et

ledit ruban adhésif (22) est détaché de ladite surface inférieure dudit élément (7) transmettant la lumière pour enlever tout surplus de résine transmettant la lumière, formé sur cet élément.

14. Procédé selon l'une quelconque des revendications 10 à 12, lorsqu'il est exécuté avec ledit moule (15, 16) retourné, ledit agent d'arrêt (20) agissant alors également de façon à retenir ledit élément transmettant la lumière en position au-dessus dudit réseau (1) de cellules photocaptrices pendant l'injection et le mûrissement.

15. Utilisation d'un photocapteur à semiconducteurs encapsulés, qui est un photocapteur tel que défini dans l'une quelconque des revendications 1 à 6, dans un système de capteur pour mise au point automatique, pour réduire la somme totale de lumière qui est réfléchie de façon interne dans ledit photocapteur.

# FIG.1

# FIG.2

# FIG.3

# FIG.4

28a

26a  26

23  23a  24

26b

25a

25b

25

27a

27b

27

28b

# FIG.5

SENSOR INPUT

Ea

S

Eb

28a  27a

27b  28b

# FIG.6

# FIG.7

# FIG.8

# FIG.9

## FIG.10

## FIG.11

# FIG.12

16  3  1  29  8  30

2'  2  4